# EUROPÄISCHE PATENTSCHRIFT

(11) **EP 3 004 827 B1**
(45) Veröffentlichungstag und Bekanntmachung des Hinweises auf die Patenterteilung: **29.11.2017**
(21) Anmeldenummer: 13730821.9
(22) Anmeldetag: 05.06.2013
(51) Int. Cl.: G01L 1/24, G01L 1/25, H01L 21/66

(54) **MESSEINRICHTUNG UND VERFAHREN ZUR ERMITTLUNG EINER DRUCKKARTE**
MEASURING DEVICE AND METHOD FOR ASCERTAINING A PRESSURE MAP
DISPOSITIF DE MESURE ET PROCÉDÉ DE DÉTERMINATION D'UNE FORCE DE PRESSION

(43) Veröffentlichungstag der Anmeldung: 13.04.2016
(73) Patentinhaber: Ev Group E. Thallner GmbH, 4782 St. Florian am Inn (AT)
(72) Erfinder: POVAZAY, Boris, A-1040 Wien (AT); PEIC, Antun, A-4782 Schärding (AT)
(74) Vertreter: Schneider, Sascha
(86) Internationale Anmeldenummer: PCT/EP2013/061583
(87) Internationale Veröffentlichungsnummer: WO 2014/194944

(56) Entgegenhaltungen:
- GB-A- 2 141 821
- US-A1- 2012 250 001
- US-B1- 8 009 276

## Beschreibung

Die vorliegende Erfindung betrifft eine Messeinrichtung gemäß Patentanspruch 1. Weiter betrifft die vorliegende Erfindung ein Verfahren gemäß Patentanspruch 8.

In der Halbleiterindustrie werden regelmäßig Substrate unterschiedlicher Größen, Formen und Materialien miteinander verbunden. Den Verbindungsvorgang nennt man Waferbonden. Das Waferbonden wird grob in Permanent- und Temporärbonden eingeteilt. Beim Permanentbonden entsteht eine nicht mehr lösbare Verbindung zwischen den beiden Substraten. Diese Permanentverbindung erfolgt beispielsweise durch Interdiffusion von Metallen, durch Kationen-Anionentransport beim anodischen Bonden oder durch die Ausbildung von kovalenten Verbindungen zwischen Oxiden und/oder Halbleitermaterialien beim Fusionsbonden, sowie beim Vernetzen von Polymeren bei Bonds mit organischen Klebern.

Beim Temporärbonden werden vorwiegend sogenannte Bondingadhäsive verwendet. Dabei handelt es sich um Klebstoffe, die durch ein Beschichtungsverfahren auf die Oberfläche eines oder beider Substrate aufgebracht werden, um als Haftvermittler zwischen den Substraten zu wirken.

Bei allen Bondingmethoden werden Bonder verwendet, um die miteinander zu verbondenden Substrate mit einem vollflächigen, möglichst gleichmäßigen Druck zu beaufschlagen. Dabei ist es von sehr großer Bedeutung, dass die Druckverteilung entlang der Fläche der Substrate optimal ist. Andernfalls können Fehlstellen (engl.: voids), z.B. durch Gaseinschlüsse, durch herausgedrücktes Material (engl.: squeeze-out), durch fehlendes Kornwachstum oder durch inhomogene Schichtdicken entstehen.

Die Druckinhomogenitäten sind vor allem auf schlecht gefertigte Druckplatten (engl.: pressure-discs), Probenhalter (engl.: wafer chucks) oder auf deren Abnützung zurückzuführen. Des Weiteren sind die unterschiedlichen elastischen Eigenschaften der Bauteile, welche die Druckbelastung auf die Substrate erzeugen, für viele Druckinhomogenitäten verantwortlich. Das ist vor allem dann der Fall, wenn die Elastizitätsmoduli der Bauteile des Bonders kleiner sind als die Elastizitätsmoduli der zu bondenden Substrate oder der Schichten, die sich zwischen den Substraten befinden. Um eine entsprechende Elastizität des Bonders zu erhalten, können Druckplatten, Probenhalter oder aus speziellen Materialien wie Graphit gefertigte Ausgleichsscheiben verwendet werden, um die optimale Bonderkonfiguration zu erhalten. In sehr vielen Fällen werden beispielsweise Graphitausgleichsscheiben entsprechender Größe zwischen die Druckplatte und dem Druckkolben (engl.: piston) fixiert. Die Verwendung solcher Ausgleichsscheiben hängt von der jeweiligen Konfiguration und der Bondart ab. Graphitausgleichsscheiben werden bis heute am häufigsten verwendet, da Sie sich sehr gut verformen, temperaturstabil sind und bei voller Druckbelastung allerdings einen entsprechenden E-Modul aufweisen. Im Allgemeinen verbessert die Verwendung derartiger Ausgleichsscheiben die Druckhomogenität.

Daher sind Verfahren bekannt, um eine quantitative Aussage über Druckverteilungen entlang der Druckflächen zu erhalten.

Die am häufigsten eingesetzte Methode ist die Auswertung der Farbinformation auf Papier, welches durch das Platzen von Farbkügelchen bei hohem Druck unterschiedlich stark eingefärbt wird. Obwohl diese Methode gängige Praxis ist, hat sie Nachteile. Das Ausschneiden der Folien, das Einbauen zwischen die Druckkörper und die Entnahme sind entsprechend zeitintensiv. Darüber hinaus ist das Material aufgrund der hohen Temperaturempfindlichkeit nicht unter thermischer Belastung verwendbar, was auch Probleme bei der Reproduzierbarkeit der Ergebnisse verursacht. Ein weiteres Problem stellt die nicht verlässliche bzw, reproduzierbare numerische Auswertung der Druckdaten dar.

Eine zweite, bereits bekannte Methode wurde in der WO2012/167814A1 offenbart. Diese Methode beruht auf der Auswertung der durch die Druckbelastung hervorgerufenen Verformung von Fluidteilchen. Auch diese Methode erlaubt keine in-situ Messung der Druckverteilung zwischen den Druckkörpern.

Eine dritte, bereits bekannt Methode verwendet ein Messgerät aus hunderten von lokal verteilten Drucksensoren, welche aufwendig und vor allem kostenintensiv auf einem entsprechenden Substrat hergestellt werden müssen. Die Herstellung erfolgt mit Hilfe der Mikrosystemtechnik. Bei den Mikrosensoren handelt es sich um MEMS und/oder Halbleiterelemente, welche einen Strom, abhängig von der jeweiligen Druckbelastung, steuern können.

Die Druckschrift US 8,009,276 offenbart ein Verfahren zur Messung von Oberflächendruck auf einer Oberfläche.

Aufgabe der vorliegenden Erfindung ist es daher, eine Messeinrichtung und ein Verfahren zur Ermittlung einer Druckkarte anzugeben, mit dem die vorgenannten Nachteile zumindest überwiegend behoben werden.

Diese Aufgabe wird mit den Merkmalen der Patentansprüche 1 und 8 gelöst. Vorteilhafte Weiterbildungen der Erfindung sind in den Unteransprüchen angegeben. In den Rahmen der Erfindung fallen auch sämtliche Kombinationen aus zumindest zwei der in der Beschreibung, den Ansprüchen und/oder den Zeichnungen angegebenen Merkmale. Bei Wertebereichen sollen auch innerhalb der genannten Grenzen liegende Werte als Grenzwerte offenbart und in beliebiger Kombination beanspruchbar sein.

Der Grundgedanke der vorliegenden Erfindung besteht darin, mindestens einen physikalischen Parameter mindestens einer elektromagnetischen Welle oder mehrerer elektromagnetischer Wellen nach dem Durchlauf durch eine Messschicht, insbesondere in-situ, zu messen und aus den gemessenen Daten einen Druck, mit Vorzug eine Druckverteilung, in der Messschicht zu berechnen. Mit Vorzug werden alle zu messenden physikalischen Parameter aller Wellen vor dem Eintritt in die Messschicht und danach gemessen. Erfindungsgemäß umfasst die Messung eine Vielzahl von Signalstrecken der elektromagnetischen Wellen, also Messstrecken, wobei aus den unterschiedlichen, sich insbesondere kreuzenden, Signalstrecken in der Messschicht verortete Druckwerte aus den Messergebnissen ermittelbar sind und hierdurch eine Druckkarte, insbesondere in-situ, erstellbar ist. Diese ist elektronisch darstellbar, insbesondere in-situ, da ein funktionaler Zusammenhang besteht und eine elektronische Verarbeitung somit ermöglicht wird. Mit Vorzug wird eine Messung vor und/oder während und/oder nach einer Druckbelastung durchgeführt. Entsprechend wird eine vollständige Druckkarte vor und/oder während und/oder nach der Druckbelastung ermittelt. Die Ermittlung der Druckkarte vor der Druckbelastung dient mit Vorzug der Kalibrierung. Die Ermittlung der Druckkarte während einer Druckbelastung dient mit Vorzug der Ermittlung eines in-situ ist-Zustandes. Die Ermittlung der Druckkarte nach einer Druckbelastung dient mit Vorzug einer Ermittlung des post-Zustandes. Mit Vorzug können auch die Druckkarten untereinander verglichen werden.

Der physikalisch sinnvolle und nutzbare Wellenlängenbereich der verwendeten elektromagnetischen Wellen erstreckt sich vom Mikrowellenbereich bis zum Röntgenbereich. Vorzugsweise werden elektromagnetische Wellen im Bereich des sichtbaren Lichts verwendet. Die verwendeten elektromagnetischen Strahlen haben insbesondere eine Wellenlänge zwischen 10⁻¹² m und 1 m, mit Vorzug zwischen 10⁻⁹ m und 10⁻³ m, mit größtem Vorzug zwischen 10⁻⁷ m und 10⁻⁵ m.

Die Erfindung beruht auf dem weiteren Gedanken, druckabhängige optische Eigenschaften eines Messmaterials der Messschicht, im Folgenden auch als "optisches Material" bezeichnet, zur Ermittlung einer Druckverteilung zu verwenden.

Mit anderen Worten: Die Erfindung beschreibt eine Messeinrichtung und ein korrespondierendes Verfahren, um die Druckverteilung in einer Messschicht, welche von zwei Druckkörpern mit Zug oder Druck beaufschlagt wird, in-situ und/oder ortsaufgelöst, insbesondere absolut und/oder abhängig von der Temperatur, zu bestimmen. Der Erfindung liegt dabei weiter der Gedanke zu Grunde, die Änderung der optischen Eigenschaften der Messschicht, welche sich zwischen den Druckkörpern befindet, während der Änderung der Druckbeauschlagung ortsaufgelöst zu bestimmen. Die optischen Eigenschaften und deren Änderungen bei Druckbeaufschlagung werden mit dem Druck korreliert beziehungsweise in eine Druckkarte transformiert.

Der Erfindung liegt dabei die weitere Idee zu Grunde, die Druckabhängigkeit einer oder mehrerer optischer Eigenschaft(en) der Messschicht zwischen den beiden Druckkörpern mit mindestens einem Sender und mindestens einem Detektor/Empfänger ortsaufgelöst zu messen oder aus einem kumulativen Messsignal mittels mathematischer Analyse, wie insbesondere der Radon-Transformation, auf den Ort des jeweiligen Druckwertes bezogen zu ermitteln, insbesondere zu berechnen, so dass sich daraus eine Druckkarte ergibt.

Erfindungsgemäße Verfahren sind Verfahren zur Rekonstruktion der Bildsignale eines Volumens, insbesondere die Radon-Transformation. Diese ist das bekannteste aller Verfahren das beispielsweise für die tomographische Rekonstruktion in der Medizintechnik herangezogen wird. Das Prinzip ist die Inversion des Integrals, welches durch Summation von Einzelereignissen entlang eines Weges entsteht und über die Messung entlang mehrerer Raumrichtungen entsteht.

Beim Low-Coherence-Tomography-Ansatz ist es ist insbesondere auch möglich, den erfindungsgemäßen Ansatz mit einer Laufzeitanalyse zu kombinieren - dabei wird die Ortsrekonstruktion nur entlang einer Ellipse (mit dem Detektor und dem Sender im Brennpunkt) disambiguiert.

Mittels der vorgenannten mathematischen und physikalischen Modelle werden kumulierte Messsignale auf örtlich diskrete Messsignale zurückgeführt. Es wird daher offenbart, dass jeder mathematische Algorithmus, mit dessen Hilfe Umrechnungen zwischen der lokalen Druckbelastung und den Ausgangssignalen durchgeführt werden kann, geeignet ist, um die erfindungsgemäßen Ausführungsformen zu betreiben.

Die Korrelation zwischen den (lokalen) optischen Eigenschaften und den vorherrschenden (lokalen) Druckverhältnissen kann theoretisch und/oder empirisch aufgestellt werden. Es existieren sehr exakte physikalische Modelle mit deren Hilfe der Zusammenhang zwischen Materialeigenschaften und/oder optischen und/oder mechanischen Eigenschaften beschrieben werden kann. Dennoch wird eine empirische Ermittlung und vor allem Eichung erfindungsgemäß bevorzugt. In einer ersten Ausführungsform erfolgt die empirische Eichung vor allem dadurch, dass eine vollflächige Druckbeaufschlagung des erfindungsgemäßen Messgeräts mit einer definierten Kraft, bei einer gewissen Temperatur erfolgt. Im Idealfall sollten die ermittelte Änderung der optischen Eigenschaften, und damit die Druckbeaufschlagung, unabhängig vom Ort sein und damit eine homogene Druckkarte liefern. Auf Grund der Tatsache, dass nicht alle Bauteile, welche die Druckbeaufschlagung hervorrufen, perfekt gefertigt werden können, werden bei einem entsprechende Eichvorgang Druckkarten bzw. Karten der Änderung optischer Eigenschaften, im Weiteren einfach nur mehr als Karten bezeichnet, ermittelt, die eine leichte Abweichung vom Idealzustand darstellen. Denkbar wäre eine gezielte Nachbearbeitung der verwendeten Bauteile, also eine Anpassung der Maschine bzw. der Bauteile, oder eine Verwendung der eben ermittelten Karte als "Nullkarte". Die ermittelte Nullkarte wird von der später im tatsächlichen Bondprozess ermittelten Karte, insbesondere vektoriell, abgezogen/subtrahiert.

In einer weiteren besonderen Ausführungsform wird das Messgerät auf folgende Art und Weise kalibriert. Das Messgerät wird schrittweise, insbesondere punktförmig, mit einem entsprechenden Druckkörper belastet. Der Druckkörper hat eine extrem dünne Spitze. Die durch den Druckkörper auf das erfindungsgemäße Messgerät ausgeübte Kraft wird über eine Kraftmessvorrichtung am Druckkörper kontrolliert und/oder eingestellt und/oder gemessen. Gleichzeitig wird für jede Punktbelastung ein erfindungsgemäßes Signal aufgezeichnet, welches sich eindeutig auf die entsprechende Punktbelastung zurückführen lässt. Durch die vorgestellte punktförmige Belastung der erfindungsgemäßen Ausführungsform ist nicht nur eine Eichung des Messgeräts, sondern auch eine Nullpunktsetzung möglich, sodass allfällige, im erfindungsgemäßen Messgerät vorhandenen Inhomogenitäten, welche die lokale Druckauswertung stören können, von vornherein ausgeschlossen werden können.

Die Erfindung umfasst somit folgende Lösungsansätze/Vorteile:
- eine in-situ Messung der Druckverteilung entlang der Druckflächen der Substrate wird ermöglicht, so dass die Auswertung der Druckverteilung vor und/oder bevorzugt während dem Bondprozess, insbesondere innerhalb der Bondkammer durchführbar ist,
- es wird ermöglicht, die Druckverteilung direkt in einem Bondinterface, bzw. in einer beliebigen Schicht des Substratstapels, insbesondere innerhalb einer Temporärbondschicht, beispielsweise eines Klebers, und/oder während eines Bondvorgangs zu bestimmen, ohne ein Messgerät zwischen die Druckkörper einzubringen,
- verortete, insbesondere absolute, Druckwerte der Druckverteilung, auch über hinreichend große Druckflächen, mit großer Präzision und über einen großen Temperaturbereich bei hoher Ortsauflösung sind ermittelbar.
- praktisch kein Materialverbrauch.

Die Erfindung erlaubt die in-situ Vermessung der Druckverteilung zwischen zwei Druckkörpern. Entsprechend konstruierte Sensoren sind wiederverwertbar, flexibel, schnell in jede Art von Bonder einbaubar, auf lange Zeit gesehen kostengünstiger als die (sehr teuren) Druckfolien gemäß Stand der Technik, weniger arbeitsintensiv und erlauben so eine schnelle und zielgerichtete Prozessoptimierung. Ein weiterer erfindungsgemäßer Vorteil besteht vor allem darin, die Druckverteilung auch unter einer beliebigen Temperaturbelastung ermitteln zu können. Die optischen Eigenschaften eines Materials hängen im Allgemeinen von der Temperatur ab. In diesem Fall muss der Zusammenhang zwischen der Änderung der optischen Eigenschaften und der Temperatur bekannt sein und kann dann herangezogen werden um eine entsprechende erweiterte Eichung des Messgeräts für unterschiedliche Temperaturen vorzunehmen. Die erweiterte Eichung entspricht dann mehreren einzelnen Eichung bei unterschiedlichen Temperaturen.

Zur Ermittlung der entstehenden Druckverteilung zweier Druckkörper wird die Messeinrichtung als Sensor auf dem unteren, zweiten Druckkörper platziert. Die Druckkörper fahren mit dem Sensor auf Kontakt. Die zwischen den Druckkörpern entstehende Druckverteilung belastet das optische Material der Messschicht und ändert damit eine vom Druck abhängige optische Eigenschaft des Materials der Messschicht. Zur ortsabhängigen Bestimmung der Druckverteilung als Druckkarte wird durch mindestens einen Sender ein optisches Signal am Rand der Messschicht eingekoppelt, also in die Messschicht gesendet. Das Signal durchdringt die Messschicht entlang einer Messstrecke oder eines Flächensegments und wird an einer dem Sender abgewandten, mit Vorzug genau gegenüberliegenden Seite, von mindestens einem als Detektor ausgebildeten Empfänger aufgefangen und gemessen. Das auf diese Weise durch die Messschicht gesendete Signal hat entlang der Signalstrecke oder mehreren Signalstrecken bei Druckbeaufschlagung mindestens eine (kumuliert erfasste) Änderung mindestens einer seiner optischen Eigenschaften erfahren.

Durch Aufnahme mehrerer, sich insbesondere kreuzender, Signalstrecken ist die Ermittlung einer Druckkarte erfindungsgemäß möglich.

Erfindungsgemäß denkbar als vom Empfänger zu erfassende Eigenschaften sind beispielsweise folgende, einzeln oder in Kombination:
- (Änderung der) Intensität,
- (Änderung der) Polarisation,
- (Änderung der) Wellenlänge oder Frequenz,
- (Änderung des) Brechungsindex,
- (Änderung der) Mode

Da die von dem Empfänger oder den Empfängern aufgefangenen Signale das Ergebnis der Kumulation aller Signaländerungen entlang der jeweiligen Signalstrecke sind, wird erfindungsgemäß eine mathematische Transformation angewandt, um die Änderung der optischen Eigenschaft des optischen Materials in der Messschicht als Funktion des Ortes zu erhalten. Dafür werden erfindungsgemäß mehrere Messungen mit unterschiedlichen Sender- und/oder Empfängerstellungen entlang des Umfangsrandes der Messschicht oder der Messeinrichtung aufgenommen, wobei sich insbesondere jede Signalstrecke mit mindestens einer anderen Signalstrecke kreuzt.

Die kumulierten Ausgangssignale werden jeweils als Funktion der Winkelposition des Senders und/oder Detektors aufgezeichnet. Eine erfindungsgemäße mathematische Transformation zur Umrechnung der kumulierten Signale in die Änderung der optischen Signale als Funktion der Position innerhalb der Messschicht zur Erstellung einer Druckkarte ist beispielsweise die Radon-Transformation. Durch die Anwendung der Radon-Transformation erhält man die Änderung der optischen Eigenschaft an jedem beliebigen Ort, insbesondere an Kreuzungspunkten von sich kreuzenden Signalstrecken, einer der erfassten Signalstrecken des optischen Materials als Funktion des Drucks. Da die Änderung der optischen Eigenschaft(en) des optischen Materials mit dem Druck korreliert werden kann, ergibt sich damit eine Möglichkeit der Aufnahme der Druckverteilung zwischen den Druckkörpern.

Im Weiteren werden erfindungsgemäße Ausführungsformen beschrieben, mit welchen die Druckverteilung erfindungsgemäß ermittelt werden kann.

In einer ersten erfindungsgemäßen Ausführungsform wird das optische Material vollflächig über die gesamte Messschicht verteilt. Für alle folgenden erfindungsgemäßen Ausführungsformen werden elektromagnetische Signale durch einen Sender an zumindest einer Stelle am Umfangsrand der Messschicht eingekoppelt, die entlang einer Signalstrecke oder bevorzugt flächenmäßig, also mit mehreren Signalstrecken, verlaufen. Entlang der Signalstrecken ändert sich zumindest eine ihrer physikalischen Eigenschaften auf Grund der zu ermittelnden Druckverteilung.

Der Detektor (Empfänger) am Austritt des Signals aus der Messschicht (also am Ende jeder Signalstrecke) erhält daher ein entlang der Messtrecke entweder aufsummiertes (kumuliertes) oder zumindest kontinuierlich verändertes Messsignal. Mathematisch gesehen wird erfindungsgemäß also die kumulierte Änderung der aufgenommenen Eigenschaften entlang jeder Signalstrecke durch eine Abbildungsvorschrift in einem Messsignal abgebildet beziehungsweise als Wert erfasst.

Um die erfindungsgemäße Druckverteilung zu bestimmen, werden der Sender und/oder Detektor/Empfänger entlang der Außenkontur oder des Umfangsrandes der Messschicht bewegt und mehrere Messsignale mehrerer Signalstrecken ermittelt und diese mit einer mathematischen Transformation auf die lokalen Messsignale umgerechnet. Die lokalen Messsignale sind dann in eindeutiger Weise abhängig von der lokalen Druckbelastung. Die bevorzugte Transformation für die Umrechnung ist die Radon-Transformation. Die mathematischen Zusammenhänge zwischen den ermittelten Messwerten der physikalischen und/oder optischen Eigenschaften und dem Druck werden insbesondere empirisch ermittelt.

In einer bevorzugten Ausführungsform der Erfindung kann an einer oder an mehreren Druckflächen der Messschicht jeweils eine Reflexionsschicht angeordnet sein, um die optischen Eigenschaften der Messschicht beziehungsweise die Messwerte so wenig wie möglich durch die Substrate oder Druckkörper zu beeinflussen und ein reproduzierbares Ergebnis zu liefern.

In einer ersten erfindungsgemäßen Ausführungsform ist die Messschicht Teil eines separaten Sensors als Messeinrichtung. Der Sensor besteht in jeder Ausführungsform aus einem unteren Substrat, einer Messschicht und einem oberen Substrat. Die Substrate besitzen vorzugsweise die Form des Drucksensors oder im Allgemeinen eine durch den Messbereich vorgegebene Form. Sie können rechteckig, rund oder beliebig anders geformt sein. Bevorzugt weisen die Substrate eine kreisrunde Form auf. Bei kreisrunden Substraten ist der Durchmesser größer als 10⁻³ m, mit Vorzug größer als 10⁻² m, mit größerem Vorzug größer als 10⁻¹ m, mit allergrößtem Vorzug größer als Im. Wird der Sensor für Druckverteilungsmessungen in der Halbleiterindustrie verwendet, beträgt der Durchmesser der Substrate mit Vorzug 1 Zoll, 2 Zoll, 3 Zoll, 4 Zoll, 5 Zoll, 6 Zoll, 8 Zoll, 12 Zoll, 18 Zoll oder mehr als 18 Zoll.

Die Dicke der Substrate hängt von der Anwendung ab. In der Mehrzahl der Fälle ist die Dicke größer als 10 µm, mit Vorzug größer als 100 µm, mit größerem Vorzug größer als 1000 µm, mit allergrößtem Vorzug größer als 2000 µm, mit allergrößtem Vorzug größer als 5000 µm. Im Allgemeinen können die Dicken der beiden Substrate unterschiedlich sein. Mit Vorzug sollten die Dicken der Substrate des Sensors den Dicken der später real zu bondenden Substrate entsprechen. Der Absolutbetrag zwischen den Dicken der Substrate des Sensors und den später real zu bondenden Substraten sollte kleiner sein als 1mm, mit Vorzug kleiner al 0.1mm, mit größerem Vorzug kleiner als 0.01mm, mit größtem Vorzug kleiner als 1µm, mit größtem Vorzug kleiner als 0.1µm, mit allergrößtem Vorzug kleiner als 0.01µm.

Um eine optimale, vollständige und vor allem homogene Druckübertragung zwischen den Druckkörpern und der Messschicht zu gewährleisten, weist jedes Substrat erfindungsgemäß eine möglichst homogene Dicke auf. Die Dickenschwankung (engl.: total thickness variation, TTV) eines Substrats ist kleiner als 100 µm, mit Vorzug kleiner als 10µm, mit größerem Vorzug kleiner als 1 µm, mit größtem Vorzug kleiner als 100 nm, mit allergrößtem Vorzug kleiner als 10 nm. Die mittlere Rauheit ist kleiner als 1000 nm, mit Vorzug kleiner als 100 nm, mit größerem Vorzug kleiner als 10 nm, mit größtem Vorzug kleiner als 1 nm, mit allergrößtem Vorzug kleiner als 0.1 nm. Mit Vorzug sollten die Bauteile, vor allem die verwendeten Substrate, des Sensors möglichst ähnliche elastische Eigenschaften haben, wie die später real zu bondenden Substrate. Der Absolutbetrag der Differenz zwischen den E-Moduli der Substrate des Sensors und den später real zu bondenden Substraten sollte kleiner sein als 1000 MPa, mit Vorzug kleiner als 100MPa, mit größerem Vorzug kleiner als 10 MPa, mit größtem Vorzug kleiner als 1MPa.

Die Substrate sind mit Vorzug mechanisch isotrop, um die Druckverteilung von den Druckkörpern homogen auf die Messschicht übertragen zu können. Daher besitzen die Substrate bevorzugt eine amorphe Mikrostruktur.

Wenn die Mikrostruktur der Substrate polykristallin ist, sind die Substrate mit Vorzug aus einem Material gefertigt, dessen Kristallite kristallisotrope mechanische Eigenschaften besitzen. Das ist vor allem bei Materialien mit kubischer Kristallstruktur der Fall. Kubische Materialien besitzen daher mit Vorzug einen Zenerschen Anisotropiefaktor (ZA) der kleiner ist als 9, mit Vorzug kleiner als 7, mit größerem Vorzug kleiner als 5, mit noch größerem Vorzug kleiner als 3, mit allergrößtem Vorzug kleiner als 2, mit allergrößtem Vorzug 1. Das einzig bekannte Metall mit einem ZA von ca. 1 ist Wolfram. Wolfram wird daher als erfindungsgemäß bevorzugtes Metall für eine homogene Druckübertragung offenbart.

Ein ebenfalls bevorzugtes Material für die erfindungsgemäße Ausführungsform ist Kohlenstoff, insbesondere in Form von Graphit, mit größerem Vorzug als Diamant.

Im Falle eines einkristallinen Substrats ist dieses mit Vorzug so geschnitten, dass es innerhalb seiner Schnittebene mechanisch isotrop ist (engl.: in-plane isotrop). Im Fall eines einkristallinen Substrats, welches ein kubisches Kristallgitter besitzt, ist das Substrat daher mit Vorzug so geschnitten, dass dessen Oberfläche eine kristallographische (111) Ebene ist bzw. die kristallographische Richtung <111> normal auf die Substratoberfläche steht. Im Fall eines einkristallinen Substrats, welches ein hexagonales Kristallgitter besitzt, ist das Substrat mit Vorzug so geschnitten, dass dessen Oberfläche parallel zur kristallographischen (0001) Ebene ist.

Das optische Material ist vollflächig zwischen dem unteren und oberen Substrat verteilt. Das optische Material kann durch alle bekannten Prozesse auf dem unteren und/oder oberen Substrat aufgetragen werden, vorzugsweise durch PVD, CVD, PECVD, atomic layer deposition (ALD), molecule layer deposition (MLD) elektrochemische Abscheidung, Plattieren, Laminieren, Spincoaten, Sprühbelacken. Darüber hinaus kann die optische Schicht auch aus einem homogenen Materialblock z.B. durch Läppen, Polieren und Schleifen gefertigt werden.

Das untere Substrat, die Messschicht und das obere Substrat bilden bevorzugt einen, mit Vorzug permanent verbundenen, nicht trennbaren, Sensor. Die Art und Weise wie unteres Substrat, Messschicht und oberes Substrat zusammenhalten. ist beliebig. Erfindungsgemäß denkbar ist die Verwendung eines optischen Materials, das gleichzeitig als Kleber wirkt und durch einen Bondprozess das unteren mit dem oberen Substrat permanent verkleben kann. Eine andere erfindungsgemäß denkbare Möglichkeit wäre die Verschweißung der Messschicht mit dem unteren und oberen Substrat über die Ausbildung eines Metall- oder Fusionbonds.

In einer weiteren erfindungsgemäßen Ausführungsform der vollflächigen Variante ist die Messschicht nicht Teil eines eigens hergestellten Sensors sondern Teil des zu bondenden Waferstapels.

Die erfindungsgemäß relevanten Teile sind die Sender, die Messschicht und die Detektoren/Empfänger. Die Ausnutzung der optischen Eigenschaften einer Schicht des zu verbondenden Waferstapels erlaubt die einmalige und völlig neuartige Vermessung der Druckverteilung während des eigentlichen Bondvorgangs. Das erfindungsgemäße Messprinzip kann somit auf eine Schicht als Messschicht angewendet werden, die Teil eines tatsächlich zu bondenden Substratstapels ist. Es muss sich also bei der Messschicht nicht notwendigerweise um die Messschicht eines separaten Sensors handeln. Man kann mit der hier vorgestellten und offenbarten Methode also auch eine in-situ Messung der Druckverteilung in einer Schicht in einem Bonder durchführen. Die erfindungsgemäße Messschicht muss zumindest eine erfindungsgemäß nötige druckabhängige optische Eigenschaft aufweist.

Die Auswertung der Messsignale einer vollflächigen Messschicht mit optischem Material erfolgt erfindungsgemäß wie folgt:
In einer ersten erfindungsgemäßen Ausführungsform verwendet man die optische Eigenschaft der Doppelbrechung, um die erfindungsgemäße Druckverteilung in der Messschicht zu erhalten. Unter Doppelbrechung versteht man den Vorgang der Aufspaltung eines einfallenden Strahls in einen ordentlichen und einen außerordentlichen Strahl, deren elektrische bzw. magnetische Felder zueinander linear polarisiert sind. Grundsätzlich zeigen nur optisch anisotrope Materialien Doppelbrechung. Im Allgemeinen werden allerdings auch optisch isotrope Materialien unter Druckbelastung optisch anisotrop. Das erfindungsgemäße optische Material muss daher zumindest eine vom Druck abhängige optische Anisotropie aufweisen, um den gewünschten Effekt der Doppelbrechung hervorzurufen.

Eine Ausführungsform des erfindungsgemäßen Verfahrens besteht darin, ein elektromagnetisches, monochromatisches Signal eines Senders über einen Polarisator in die Messschicht einzukoppeln. Der Polarisator sorgt dafür, dass nur elektromagnetische Wellen einer bestimmten Schwingungsebene in die Messschicht gelangen. Durch die optische Eigenschaft der Doppelbrechung wird der eingekoppelte Strahl im Allgemeinen in einen ordentlichen und einen außerordentlichen Strahl geteilt. Die Schwingungsebenen der elektrischen Felder von ordentlichem und außerordentlichem Strahl werden durch eine lokale Druckbelastung gedreht, sodass ein am Ausgang der Messschicht angebrachter Empfänger die neuen Schwingungsebenen von ordentlichem und/oder außerordentlichem Strahl detektieren kann. Mit Vorzug wird allerdings einer der beiden Strahlen auf dem Weg durch die Messschicht entlang der Signalstrecke vollkommen absorbiert oder verlässt bevorzugt die Messschicht. Der in der Messschicht verbleibende Strahl nutzt mit Vorzug das physikalische Phänomen der Totalreflexion um sich entlang der Signalstrecke bis zum Ende der Messschicht durchzuarbeiten. Das am Detektor ankommende Signal ist also eine entlang der Signalstrecke, insbesondere zumindest überwiegend, vorzugsweise ausschließlich, durch die Druckverteilung entlang der Messtrecke veränderte, Drehung der Schwingungsebene. Die Ermittlung der lokalen Änderung der Schwingungsebene erfolgt wieder durch die Aufnahme mehrerer Messtrecken durch die Bewegung von Sender und/oder Detektor und die Anwendung einer entsprechenden mathematischen Transformation, mit Vorzug der Radon-Transformation.

In einer weiteren erfindungsgemäßen Ausführungsform wird die optische Eigenschaft des Brechungsindex verwendet, um die erfindungsgemäße Druckverteilung in der Messschicht zu ermitteln. Der Brechungsindex des optischen Materials der Messschicht ist dabei im unbelasteten Zustand größer als 1, mit Vorzug größer ist 1,5, mit größtem Vorzug größer als 2,0, mit größtem Vorzug größer als 2,5, mit noch größtem Vorzug größer als 3,0, mit allergrößtem Vorzug größer als 3,5. Der Brechungsindex der Materialien, welche die Messschicht begrenzen, weiterhin als Begrenzungsmaterialien oder Substratmaterialen bezeichnet, ist im unbelasteten Zustand insbesondere größer als der Brechungsindex der Messschicht, vorzugsweise kleiner als 3,5, mit Vorzug kleiner ist 3,0, mit größtem Vorzug kleiner als 2,5, mit größtem Vorzug kleiner als 2,0, mit noch größtem Vorzug kleiner als 1,5. Mit Vorzug ändert sich der Brechungsindex der Begrenzungsmaterialien unter Druckbelastung nicht oder nur sehr wenig. Durch die unterschiedlichen Brechungsindices zwischen dem optischen Material der Messschicht und den Begrenzungsmaterialien wird das eingekoppelte Signal durch die Totalreflexion mit Vorzug überwiegend in der Messschicht gehalten.

Ein erfindungsgemäßer Gedanke besteht darin, dass durch eine lokale Druckveränderung das optische Material lokal komprimiert wird und damit eine lokale Änderung des Brechungsindex des optischen Materials verursacht wird. Damit ändert sich das Übertrittsverhalten der elektromagnetischen Strahlung aus der Messschicht in die Umgebung, also in die Begrenzungsmaterialen beziehungsweise die Substrate. Darunter ist vor allem eine lokale Änderung der Intensität zu verstehen. Das Übertrittsverhalten der elektromagnetischen Strahlung wird bevorzugt mit den Fresnelschen Gleichungen beschrieben. Das am Detektor ankommende Signal ist also eine entlang der Signalstrecke, insbesondere überwiegend, vorzugsweise ausschließlich, durch die Druckverteilung entlang der Signalstrecke veränderte Intensität der elektromagnetischen Strahlung. Die Ermittlung der lokalen Intensität und damit des lokalen Brechungsindex und des lokalen Drucks erfolgt erfindungsgemäß durch die Aufnahme mehrerer Messtrecken durch die Bewegung von Sender und/oder Detektor entlang des Umfangsrandes und die Anwendung der Radon-Transformation.

In einer dritten erfindungsgemäßen Ausführungsform werden als optische Eigenschaft transversal-elektromagnetischen Wellen (TEM-Welle) verwendet. Unter einer TEM-Welle versteht man eine elektromagnetische Welle, deren elektrische und magnetische Feldkomponenten in Ausbreitungsrichtung verschwinden. TEM-Wellen bilden sich nur unter erfindungsgemäßen Randbedingungen. Unter einer Randbedingung versteht man eine einschränkende geometrische Bedingung, die vorgibt, welche Funktionswerte die betrachtete Funktion, im Spezialfall das elektrische und/oder magnetische Feld, besitzt. Durch erfindungsgemäße Randbedingungen bilden sich insbesondere stehende, transversal-elektromagnetische Wellen aus. Die Verteilung der elektromagnetischen Felddichte im Raum ist vorzugsweise streng symmetrisch. Die unterschiedlichen Ausbildungsformen der stehenden Wellen bezeichnet man als Moden. Vergleichbar sind die Moden der TEM-Wellen mit den stehenden Wellen der Akustik oder den stehenden Wellen, die sich bei eingespannten Seilen bilden können.

Ein weiterer erfindungsgemäßer Gedanke besteht darin, eine monochromatische elektromagnetische Welle unter einem gewissen Einfallswinkel in die Messschicht einzukoppeln. Durch die geometrischen Randbedingungen bildet sich eine der möglichen Moden aus. In der Messschicht entstehen also stehende transversal-elektromagnetische Wellen. Analysiert man in einem Querschnitt der Messschicht die Intensität entlang der Querschnittsfläche, erhält man eine symmetrische Intensitätsverteilung. Die symmetrische Intensitätsverteilung kann für einfache geometrische Randbedingungen, wie jene der ausgedehnten dünnen Messschicht, durch eine mathematische Funktion dargestellt werden. Diese mathematische Funktion enthält sogenannte Ordnungsparameter, mit deren Hilfe erfindungsgemäß Rückschlüsse auf die Anzahl der Maxima erhalten werden.

Der erfindungsgemäße Gedanke dieser erfindungsgemäßen Ausführungsform besteht also darin, die Intensitätsverteilung auf der Empfängerseite zu registrieren. Durch eine Druckbelastung entlang der Messtrecke wird die Geometrie dahingehend verändert, dass die Messschicht insbesondere dünner wird. Dadurch ändern sich die Randbedingungen für die TEM Welle. Die lokale Änderung der Randbedingungen hat somit einen Einfluss auf das gemessene Intensitätssignal am Ende der Messtrecke. Um die Druckverteilung entlang der gesamten Messfläche zu erhalten, werden Signale von mehreren unterschiedlichen Detektorpositionen bei unterschiedlichen Senderpositionen aufgenommen. Bei den Signalen handelt es sich im konkreten Fall nicht um integrale, sondern um Flächensignale. Es wird also die Intensitätsverteilung entlang eines Raumwinkels um die Normale eines Flächendetektors aufgenommen. Die so ermittelte lokale Intensitätsverteilung in der Messschicht kann wieder mit dem Druck in Verbindung gebracht werden und erlaubt so die Bestimmung der gesamten Druckverteilung.

Die Anzahl der Sender ist erfindungsgemäß größer gleich als eins, mit Vorzug größer als 3, mit größerem Vorzug größer als 5, mit größtem Vorzug größer als 8. Die Anzahl der Detektoren ist erfindungsgemäß größer gleich als eins, mit Vorzug größer als 3, mit größerem Vorzug größer als 5, mit größtem Vorzug größer als 8. Insbesondere werden der Sender und der Empfänger/Detektor integral ausgebildet oder Sender und/oder Empfänger sind, insbesondere gleichmäßig und/oder symmetrisch, am Umfangsrand der zu vermessenden Messschicht angeordnet oder werden rotatorisch bei konstantem Radius um die Messschicht bewegt. Die Sender können als Punkt-, Linien- oder bevorzugt Flächenstrahler ausgeführt sein. Die Detektoren können als Punkt-, Linien oder Flächendetektoren ausgeführt sein. Dieser Messvorgang kann auch als Tomographie bezeichnet werden.

In einer weiteren erfindungsgemäßen Ausführungsform sind Reflektoren innerhalb der Messschicht vorgesehen. Bei den Reflektoren handelt es sich um Objekte, mit Vorzug Kugeln oder Zylinder, deren Achse parallel zur Normalen der Messschicht beziehungsweise parallel zur Druckbeaufschlagungsrichtung liegt, welche einen hohen Reflektivitätsgrad bei der Wellenlänge des eingekoppelten Messsignals besitzen. Der Sender koppelt eine elektromagnetische Strahlung mit vorgegebener Frequenz in die Messschicht ein. Der Detektor misst nach einer vorgegebenen Zeit ein Echo des eingekoppelten Signals. Sender und Detektor können sich an unterschiedlichen Positionen des Umfangs der Messschicht befinden. Sender und Detektor sind vorzugsweise synchronisiert, so dass der Detektor mit der Zeitmessung beginnt, sobald der Sender das Signal in die Messschicht einkoppelt. Nach einer gewissen Zeit misst der Detektor ein Echosignal eines Reflektors. Das elektromagnetische Signal hat beim Durchqueren der Messschicht eine Änderung in seiner Intensität erfahren. Der Intensitätsverlust ist ein Maß für die Absorption entlang der Signalstrecke.

Die Druckinformation an der Position eines Reflektors erfolgt durch die Messung der Änderung des Ausgangs- vom Eingangssignal. Mit Vorzug wird die Abnahme an Intensität als Messgröße herangezogen.

In einer weiteren erfindungsgemäßen Ausführungsform der Messeinrichtung als separater Sensor ist das optische Material Teil einer oder mehrerer Faseroptiken, welche über die gesamte Messschicht verteilt ist/sind beziehungsweise diese von einer Eintrittsstelle am Umfangsrand bis zu einer Austrittsstelle am Umfangsrand durchdringen. Die Fasern sind dabei mit Vorzug in ein mechanisch isotropes Material, des Weiteren nur mehr als Matrix bezeichnet, eingebettet. In besonderen Ausführungsformen sind die Fasern von einem Fluid, insbesondere einer Flüssigkeit, in einer ganz besonderen Ausführungsform von einer gasförmigen Atmosphäre umgeben. Unter Atmosphäre wird in diesem Zusammenhang auch ein Vakuum verstanden.

Der Sensor besteht aus einem unteren Substrat, einer als Matrix ausgebildeten Messschicht, mindestens einer in die Messschicht eingebetteten Faseroptik und einem oberen Substrat. Die entsprechenden Sender und Empfänger sowie weitere optische Geräte werden an der Außenseite der Faseroptiken angebracht und erfindungsgemäß verwendet. Erfindungsgemäß denkbar wäre auch die Verwendung einer Siliconmatrix, in der die Fasern eingebettet werden. Der Sensor würde dann kein entsprechendes oberes und/oder unteres Substrat besitzen, sondern als Matte ausgebildet sein.

In einer erfindungsgemäßen Ausführungsform der Faseroptikvariante ist die Faseroptik zu einer Spirale, mit Vorzug einer archimedischen Spirale, aufgerollt und in die Matrix eingebettet. An definierten Positionen befinden sich Referenzpunkte, an denen die Druckbeanspruchung ermittelt wird. Die Beeinflussung der optischen Eigenschaften wird nicht am Ende der der Faseroptik, sondern am Eingang der Faseroptik, registriert. Der Abstand des Referenzpunktes vom Eingang wird durch eine Laufzeitmessung oder spektrale Kodierung der Referenzpunkte bestimmt.

In einer bevorzugten Ausführungsform befindet sich in Richtung der Normalen der Messschicht ein die Faseroptik berührender Druckkörper. Der Druckkörper besitzt mit Vorzug einen hohen E-Modul, sodass er unter einer Druckbeanspruchung möglichst nicht seine Form ändert. Der E-Modul ist dabei größer als 10 MPa, mit Vorzug größer als 100 MPa, mit größerem Vorzug größer als 1 GPa, mit größtem Vorzug größer als 10 GPa, mit allergrößtem Vorzug größer als 100 GPa, am idealsten größer als 1000 GPa. Durch eine Druckbeanspruchung der Faseroptik wird diese auf den extrem steifen und damit wenig komprimierbaren Druckkörper gedrückt, so dass sich lokal ihre optische Eigenschaft ändert. Bei der Änderung der optischen Eigenschaft kann es sich wiederum um eine Doppelbrechungsänderung, eine Änderung im Brechungsindex, der Dichte des optischen Materials in der Faseroptik handeln. Der Sender ist mit Vorzug eine polychromatische Quelle, mit größerem Vorzug eine polychromatische, wellenlängenselektierende Quelle, daher eine Quelle, mit deren Hilfe eine oder mehrere definierte Wellenlängen oder Wellenlängenbereiche selektierbar und in die Faseroptik einkoppelbar sind. Die Position eines jeden Referenzpunktes, an dem sich ein erfindungsgemäßer Druckkörper befindet, wird durch eine interferometrische Messung und/oder eine Laufzeitmessung vorgenommen. Erfindungsgemäß denkbar ist insbesondere das Einkoppeln einer monochromatischen Welle. Der Eintritt der monochromatischen Welle in die Faseroptik liefert den Zeitnullpunkt. Die monochromatische Welle durchläuft die Faseroptik. Trifft die monochromatische Welle auf einen erfindungsgemäßen ersten Druckkörper, wird ein Teil der Welle reflektiert. Das reflektierte Signal der monochromatischen Welle wird am Eingang von einem Detektor gemessen. Damit sind Signalfunktion und Laufzeit für den ersten Druckkörper bekannt. Denkbar wäre auch die Verwendung eines Interferometers zur Laufzeitdifferenzmessung. Ein Teil der monochromatischen Welle läuft über den ersten Druckkörper hinaus und trifft auf den zweiten Druckkörper, der wiederum eine entsprechende Teilreflexion zur Folge hat. Entsprechend analoge Betrachtungen gelten für alle weiteren Druckkörper entlang der Faseroptik. In einer besonderen Ausführungsform ist es denkbar, eine polychromatische Welle in die Faseroptik einzukoppeln, deren Spektrum mit Vorzug zumindest teilweise bekannt ist. Durch entsprechende Interferometer ist ein Rückschluss auf die Position des Druckkörpers und dessen Signalform möglich. Denkbar wäre auch die Verwendung unterschiedlicher, wellenlängensensitiver Druckkörper, welche mit Vorzug nur einen gewissen Teil des elektromagnetischen eingekoppelten Signals reflektieren und damit entsprechend einfach aufgeschlüsselt werden können.

In einer zweiten erfindungsgemäßen Ausführungsform der Faseroptikvariante sind mehrere Faseroptiken vorgesehen. Die Faseroptiken werden über die Messschicht hinweg in einem Gitter angeordnet. Das Gitter ist mit Vorzug rechteckig angelegt, so dass sich mehrere Faseroptiken zueinander im rechten Winkel überschneiden. Jede der Faseroptiken wirkt im Referenzpunkt als Druckkörper für die diese kreuzende Faseroptik. Am Eingang und am Ausgang einer jeden Faseroptik befinde sich jeweils ein Sender (Eingang) und ein Detektor (Ausgang). Die Messung einer Signaländerung bei Druckbeanspruchung erfolgt erfindungsgemäß an den Überschneidungspunkten/Referenzpunkten. An den Überschneidungspunkten liegen zwei Fasern quer zueinander und gleichzeitig übereinander in einem Punkt zusammen. Durch eine Druckbeanspruchung in diesem Punkt wird das optische Material in den Fasern erfindungsgemäß komprimiert, was zu einer Doppelbrechungsänderung, einer Änderung im Brechungsindex, der Dichte des optischen Materials in der Faseroptik, einer Änderung der Mode der TEM-Welle führt. Die Auswertung aller Messsignale erlaubt die Bestimmung der Herkunft der Änderung der jeweiligen optischen Eigenschaft und somit die Umrechnung in den jeweiligen lokalen Druckwert.

Die Messung der Druckverteilung zwischen den Druckkörpern erfolgt bei einem Stempeldruck von mehr als 1 N, mit Vorzug, mehr als 10 kN, mit größerem Vorzug mehr als 50 kN, mit noch größerem Vorzug mehr als 100 kN.

Die Genauigkeit der Druckwerte der Druckmessung zwischen den Druckkörpern ist besser als 20%, mit Vorzug besser als 15%, mit größerem Vorzug besser als 10%, mit größtem Vorzug besser als 5%, mit allergrößtem Vorzug besser als 1%.

Die Messung kann bei erhöhten Temperaturen erfolgen. Die Messung erfolgt bei mehr als 0°C, mit Vorzug bei mehr als 200°C, mit größerem Vorzug bei mehr als 400°C, mit noch größerem Vorzug bei mehr als 600°C, mit allergrößtem Vorzug bei mehr als 800°C. Die Temperatur weist eine Wiederholbarkeit von besser 10%, mit Vorzug besser 5%, mit größerem Vorzug besser 1%, mit größtem Vorzug besser 0.5%, mit allergrößtem Vorzug besser 0.1% auf.

Soweit die Messeinrichtung in einer Waferbearbeitungsvorrichtung, insbesondere in-situ, einsetzbar ist, lassen sich reproduzierbare und grafisch darstellbare Druckverteilungen ermitteln. Darüber hinaus ist es erfindungsgemäß möglich, die Druckflächen der Druckkörper auf Basis der Druckkarte entsprechend zu verformen, um die Druckverteilung der Druckbeaufschlagung zu optimieren. Eine weitere erfindungsgemäße Anwendung wäre die Erstellung und vor allem die Optimierung von Ausgleichsscheiben anhand der ermittelten Druckkarten. Mit besonderem Vorzug werden die Druckkarten zur Optimierung der Ausgleichsscheiben wieder unter möglichst realen Bedingungen, daher mit einem entsprechend real zu bondenden Substratstapel, ermittelt. Als Waferbearbeitungsvorrichtung gelten vor allem Bonder, Schleifgeräte, Poliergeräte, Metrologiegeräte.

In einer vorteilhaften Ausführungsform der Erfindung sind der/die Sender und/oder der/die Empfänger entlang des Umfangsrandes bewegbar. Mit Vorteil erfolgt die Bewegung gesteuert von der Steuerungseinrichtung, insbesondere mittels von der Steuerungseinrichtung gesteuerten Schrittmotoren. Bevorzugt erfolgt die Bewegung entlang einer zum Umfangsrand formkongruenten Bahn, insbesondere einer Ringbahn, vorzugsweise einer, insbesondere umfangsgeschlossenen, Kreisringbahn.

Mit Vorteil ist es erfindungsgemäß vorgesehen, dass die Messeinrichtung mehrere am Umfangsrand verteilte Sender und/oder mehrere am Umfangsrand verteilte, je einem, insbesondere gegenüberliegend angeordneten, Sender zugeordnete Empfänger aufweist, insbesondere mindestens zwei Empfänger je Sender.

Durch die erfindungsgemäße Maßnahme, dass jeder Sender mehrere Signalstrecken, insbesondere gleichzeitig, aussendet und/oder jeder Empfänger jeweils einer einzigen Signalstrecke zugeordnet ist, können am Umfangsrand mehrere Empfänger als Sender angeordnet werden, so dass die Erfassung effizienter erfolgen kann.

Weiter ist es erfindungsgemäß von Vorteil, wenn die Messeinrichtung eine Auswerteeinheit zur Bestimmung von verorteten Druckwerten der Druckkarte entlang der Signalstrecken, insbesondere durch Transformation, vorzugsweise Radon-Transformation, der von dem mindestens einen Empfänger empfangenen Signale aufweist.

Gemäß einer weiteren, vorteilhaften Ausführung der Erfindung sind durch mindestens einen Empfänger Signale erfassbar, die Auskunft über das optische Verhalten geben. Die Änderung der Signale ist mit einer Änderung der optischen Eigenschaften und damit mit einer Druckänderung verbunden. Insbesondere sind folgende optische Eigenschaften von Bedeutung:
- Doppelbrechung
- Brechungsindex
- Mode von als transversal-elektromagnetischen Wellen ausgeprägten Signalen
- Laufzeit
- spektrale Kodierung.

Ein erfindungsgemäßes Verfahren zur Ermittlung einer Druckkarte bei einer Druckbeaufschlagung einer Messschicht zwischen einem ersten Druckkörper und einem zweiten Druckkörper umfasst in seiner allgemeinsten Form folgende Schritte, insbesondere folgenden Ablauf:
- Anordnung einer Messeinrichtung nach einem der vorhergehenden Ansprüche zwischen dem ersten Drückkörper (5) und dem zweiten Druckkörper,
- Aussendung von Signalen in Form elektromagnetischer Wellen durch den oder die am Umfangsrand angeordneten Sender entlang einer durch die Messschicht verlaufenden ersten Signalstrecke und mindestens einer weiteren durch die Messschicht verlaufenden Signalstrecke,
- Empfang der Signale durch den oder die am Umfangsrand angeordneten Empfänger zum Empfang der von dem oder den Sender(n) durch die Messschicht gesendeten und bei Druckbeaufschlagung veränderbaren Signale der ersten Signalstrecke und der weiteren Signalstrecke(n).

Für eine erfindungsgemäße Vorrichtung und das erfindungsgemäße Verfahren gelten die vorgenannten, zur Messeinrichtung beschriebenen Merkmale entsprechend und umgekehrt.

Weitere Vorteile, Merkmale und Einzelheiten der Erfindung ergeben sich aus der Beschreibung bevorzugter Ausführungsbeispiele sowie anhand der Zeichnungen. Diese zeigen in:
- Fig. 1:: eine Querschnittsansicht einer erfindungsgemäßen Messanordnung mit einer erfindungsgemäßen Messeinrichtung,
- Fig. 2:: eine schematische Aufsicht auf eine erste Ausführungsform einer erfindungsgemäßen Messeinrichtung,
- Fig. 3:: eine schematische Aufsicht auf eine zweite Ausführungsform einer erfindungsgemäßen Messeinrichtung,
- Fig. 4:: eine schematische Aufsicht auf eine dritte Ausführungsform einer erfindungsgemäßen Messeinrichtung,
- Fig. 5:: ein Diagramm einer lokalen Druckverteilung entlang einer Signalstrecke L,
- Fig. 6:: eine schematische Darstellung einer Messung einer optischen Eigenschaft einer Ausführungsform der erfindungsgemäßen Messschicht,
- Fig. 7:: eine schematische Darstellung einer Messung einer optischen Eigenschaft einer Ausführungsform der erfindungsgemäßen Messschicht,
- Fig. 8:: eine schematische Darstellung einer Messung einer optischen Eigenschaft einer Ausführungsform der erfindungsgemäßen Messschicht,
- Fig. 9:: eine schematische Aufsicht auf eine vierte Ausführungsform der erfindungsgemäßen Messeinrichtung,
- Fig. 10:: eine schematische Aufsicht auf eine fünfte Ausführungsform der erfindungsgemäßen Messeinrichtung,
- Fig. 11:: eine schematische Aufsicht auf eine sechste Ausführungsform einer erfindungsgemäßen Messeinrichtung und
- Fig. 12:: eine schematische Aufsicht auf eine siebte Ausführungsform einer erfindungsgemäßen Messeinrichtung.

In den Figuren sind gleiche oder gleichwirkende Bauteile mit den gleichen Bezugszeichen gekennzeichnet.

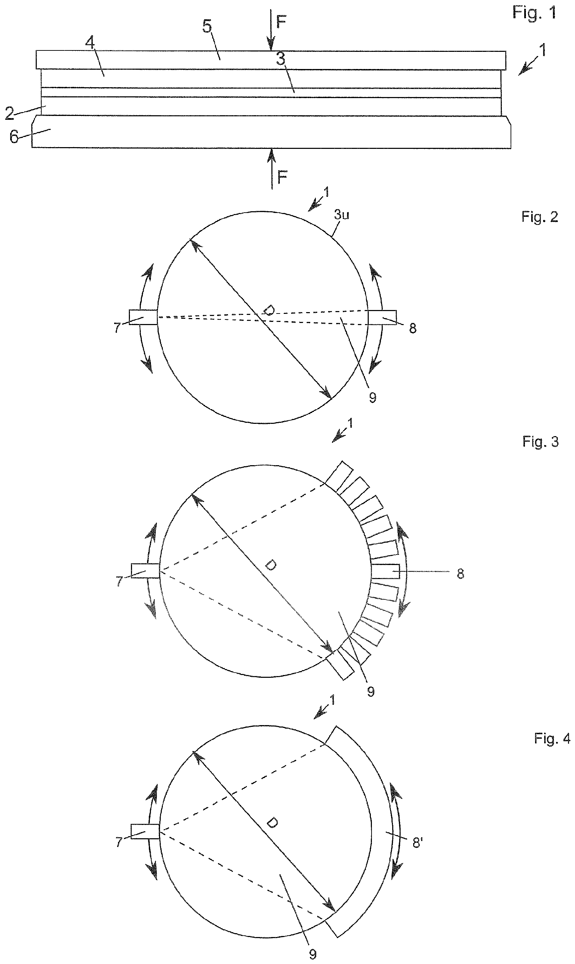

Figur 1 zeigt schematisch eine Bondvorrichtung, wobei nur ein erster, oberer Druckkörper 5 und ein zweiter, unterer Druckkörper 6 beim Bonden mit einer quer zu den Druckflächen der Druckkörper 5, 6 gerichteten Bondkraft F dargestellt sind.

Zwischen den Druckkörpern 5, 6 sind ein erstes Substrat 2 und ein zweites Substrat 4 angeordnet, die mit einer als Messschicht 3 ausgebildeten Verbindungsschicht durch die Kraftbeaufschlagung mit der Bondkraft F verbunden werden.

Die Bondkraft F steigt während der Druckbeaufschlagung von Null kurz vor dem Kontaktieren bis zu einer Bondkraft von bis zu mehreren kN an, woraus sich ein auf die Druckfläche bezogener Druck ergibt, wobei die Druckfläche beispielsweise bei einem kreisrunden Substrat mit einem Durchmesser von 300 mm berechnet werden kann.

Die Messschicht 3 ist Teil einer Messeinrichtung zur Messung von optischen Eigenschaften von durch die Messschicht 3 gesendeten Signalen, wobei die Messeinrichtung 1 entweder ein separat in die Bondkammer eingebrachter Sensor als Messeinrichtung oder eine fest in der Bondkammer installierte Messeinrichtung 1 sein kann.

Zur Messung und zum Durchleiten elektromagnetischer Wellen ist gemäß einer ersten Ausführungsform in Figur 1 ein Sender 7 an einem Umfangsrand 3u der Messschicht 3 angeordnet, der ein Signal 9 durch die Messschicht 3 entlang einer Signalstrecke sendet.

Zur erfindungsgemäßen Erfassung der gesamten Messschicht 3 sind der Sender 7 und/oder der Detektor 8, insbesondere synchronisiert, entlang des Umfangsrandes 3u bewegbar, insbesondere entlang einer ringförmigen, vorzugsweise kreisringförmigen, Umlaufbahn, die durch Pfeile dargestellt ist. Die Umlaufbahn schließt insbesondere unmittelbar an die Messschicht 3 an.

Zur Steuerung der erfindungsgemäßen Bauteile und Verfahrensschritte ist eine (nicht dargestellte) Steuerungseinrichtung vorgesehen.

Es ist erfindungsgemäß denkbar, mehrere Sender 7 und/oder mehrere Empfänger 8 am Umfangsrand 3u zu verteilen, die dann jeweils einen Abschnitt des Umfangsrandes 3u abdecken, entweder durch Bewegung oder durch Abdeckung eines größeren Teilabschnitts.

So sind in der in Figur 3 gezeigten zweiten Ausführungsform mehrere Empfänger 8 einem einziger Sender 7 gegenüberliegend zugeordnet. Der Sender 7 sendet im Vergleich zu der ersten Ausführungsform gemäß Figur 2 einen Signalstrahl aus, der einen größeren Abschnitt der Messschicht 3 erfasst und eine Vielzahl von Signalstrecken aufweist, die jeweils zu einem der Empfänger 8 führen und von diesem aufgenommen werden. Somit besteht der Vorteil dieser Ausführungsform darin, dass gleichzeitig mehrere Signale entlang eines größeren Winkelabschnitts der Messschicht 3 gleichzeitig erfasst werden können. Die erforderliche Messzeit sinkt um den Faktor der Anzahl der Empfänger 8.

Durch Bewegung des Senders 7 und dem Sender 7 zugeordneten Empfänger 8 entlang des Umfangsrandes 3 ist die gesamte Messschicht 3 erfassbar. Alternativ können am Umfang verteilte mehrere Sender 7 und jeweils zugeordnete Empfänger 8 angeordnet sein, so dass ohne Bewegung des Senders und der Empfänger 8 die gesamte Messschicht 3 erfassbar ist.

Figur 4 zeigt eine dritte Ausführungsform zur Erfassung der Messschicht 3, wobei ein Sender 7 und ein Empfänger 8' vorgesehen sind, wobei der Empfänger 8' als Linien- oder Flächendetektor, insbesondere als CCD-Detektor ausgestattet ist. Der Linien- beziehungsweise Flächendetektor ist in der Lage, Signale entlang einer Linie beziehungsweise Fläche aufzunehmen und unmittelbar weiterzuverarbeiten. Je nach Ortsauflösung des Empfängers 8' ist dieser eine Vielzahl von Signalstrecken des Signals 9 erfassend ausgebildet. Analog zu der Ausführungsform gemäß Figur 3 kann sowohl der Sender 7 als auch der Empfänger 8' entlang des Umfangsrandes 3u bewegt werden oder es werden eine Mehrzahl, insbesondere drei, Sender 7 am Umfang verteilt, mit jeweils gegenüberliegenden Empfängern 8'.

Den vorbeschriebenen Ausführungsformen ist es gemein, dass praktisch eine beliebige Vielzahl von durch die Messschicht 3 verlaufenden Signalstrecken durch entsprechend kleine Bewegungsschritte der Sender 7 und Empfänger 8, 8' erfasst werden können. Die Bewegung kann insbesondere durch Schrittmotoren erfolgen, die von der Steuerungseinrichtung gesteuert werden.

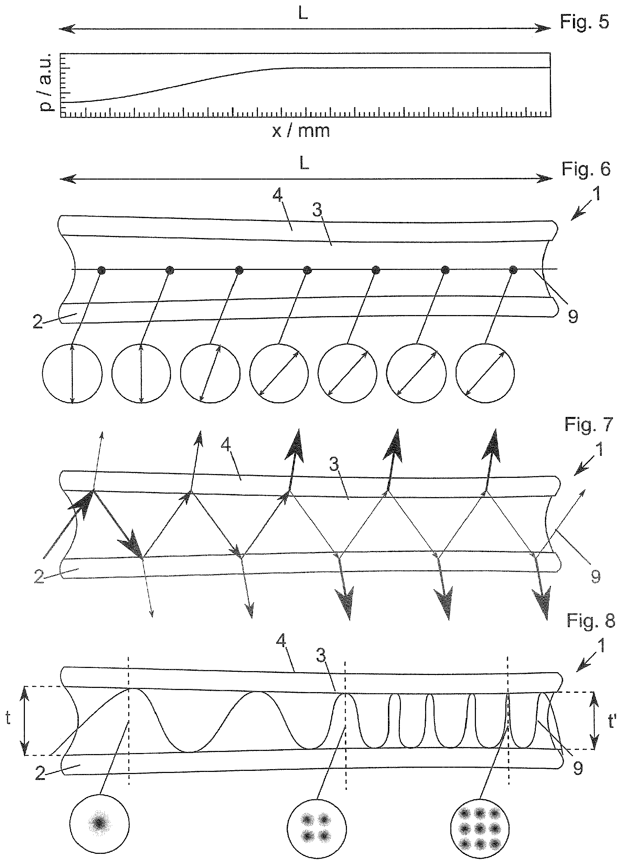

Die erfassten Daten werden von einer Auswerteeinheit (nicht dargestellt) ausgewertet, die es in Figur 5 in einem Diagramm für einen Ausschnitt L des Durchmessers D dargestellt ist. Im Diagramm ist die durch die Auswerteeinheit ausgewertete lokale Druckverteilung p gegen eine Strecke X aufgetragen und es ist erkennbar, dass sich der Druck p als Funktion des Ortes ändert. Das Diagramm gemäß Figur 5 dient als Referenz für die Druckverteilung in den durch die Figuren 6 bis 8 dargestellten Ausführungsformen, die ebenfalls den Ausschnitt L betreffen.

Figur 6 zeigt, wie sich durch die doppelbrechende Eigenschaft des optischen Materials der Messschicht 3 der Polarisationswinkel des elektrischen Feldes als Funktion des Drucks ändert. Erfindungsgemäß werden die Polarisationszustände an mindestens einem der Empfänger 8 am Ende der jeweiligen Signalstrecke nach dem Durchgang des Signals 9 durch die Messschicht 3 aufgenommen. Anschließend wird durch mathematische Transformation der lokale Polarisationszustand geschlossen und hieraus der Druck berechnet. Dies erfolgt in der Auswerteeinheit. Die Ausbreitung des Signals ist in diesem Fall als gerade Linie dargestellt, da der physikalische Parameter der Polarisation durch entsprechende Pfeile unterhalb der Figur 6 dargestellt ist. Diese entsprechen den Polarisationszuständen des elektrischen Feldes des Signals in dem jeweils gezeigten Punkt. Die Transformation und Bestimmung des lokalen Polarisationszustandes ist nur durch Aufnahme entlang verschiedener, sich überkreuzender Signalstrecken möglich.

Figur 7 zeigt die Ermittlung einer weiteren optischen Eigenschaft des optischen Materials der Messschicht 3, nämlich des Brechungsindexes. In dem Diagramm gemäß Figur 5 ist erkennbar, dass der Druck als Funktion des Ortes von links nach rechts innerhalb der Strecke L steigt. Mit steigendem Druck wird das optische Material der Messschicht 3 dichter und mit steigender Dichte steigt auch der Brechungsindex des optischen Materials. Durch die Änderung des Brechungsindex ändert sich die Reflektionseigenschaft des Signals 9 und damit seine Intensität. Die Ausbreitung des Signals 9 wird durch die Ausbreitungsrichtung der elektromagnetischen Welle des Signals 9 nach den Regeln der geometrischen Optik dargestellt. Die unterschiedliche Dicke der Pfeile repräsentiert schematisch die Intensität, die am Eintritt des Signals 9 in die Messschicht 3 hoch ist. Durch Änderung des Brechungsindexes mit fortschreitendem Weg treten immer mehr Photonen der elektromagnetischen Welle durch Änderung der Brechungseigenschaften aus der Messschicht 3 aus, was durch immer dünner werdende Pfeile dargestellt ist. Die Pfeile der die Messschicht 3 verlassenden Photonen wird mit zunehmendem Druck dicker. Auch diese optische Eigenschaft wird durch Erfassung mehrerer, sich insbesondere kreuzender, Signalstrecken entlang der Messschicht 3 durch mathematische Transformation, insbesondere Radon-Transformation, erfasst.

Figur 8 ist eine schematische Darstellung der Änderung einer TEM-Welle, durch eine von einer Druckhomogenität hervorgerufene Dickenänderung entlang des Weges L. Durch die Komprimierung ändert sich die Dicke der Messschicht 3 entlang des Weges L von t auf t', wodurch sich auch die stehende elektromagnetische Welle innerhalb der Messschicht 3 ändert. Diese Änderung der elektromagnetischen Welle führt zu einer Änderung der Mode der elektromagnetischen Welle und auch der Intensitätsverteilung. Aus der Änderung der Mode und/oder Intensitätsverteilung ist eine ortsbezogene Ermittelung des Drucks möglich, wobei entsprechend der Erfindung eine Vielzahl von Signalstrecken ausgewertet wird. Durch die Messung der Intensitätsverteilung der Moden entlang des Umfangsrandes 3u kann mittels der Transformation, vorzugsweise Radon-Transformation, auf die Intensitätsverteilung der Mode an einem bestimmten Ort der Messschicht 3 geschlossen werden. Hieraus ist der lokale Druck ermittelbar.

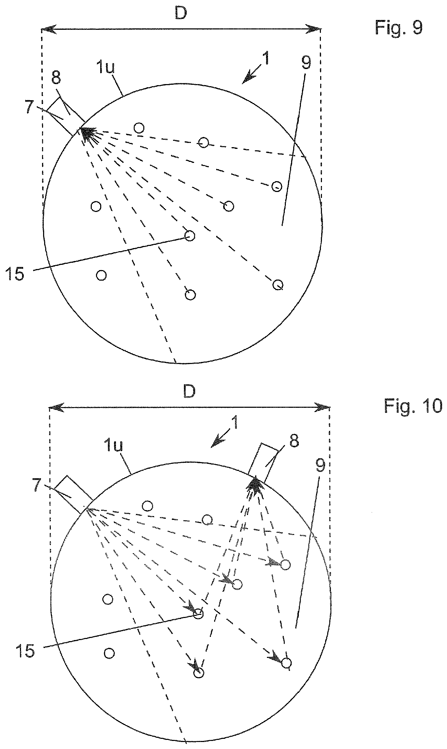

Figur 9 zeigt eine weitere Ausführungsform der Erfindung mit einer aus einem Sender 7 und einem Empfänger 8 bestehenden Sender-Empfänger-Einheit. Die Sender-Empfänger-Einheit sendet und empfängt an derselben Stelle des Umfangsrandes 3u der Messschicht 3. Der Sender 7 der Sender-Empfänger-Einheit koppelt eine elektromagnetische Welle, nämlich ein divergentes Signal 9 in die Messschicht 3 ein. Das Messsignal 9 hat eine Divergenz, mit der ein Flächenabschnitt der Messschicht 3 abgedeckt wird. Das Signal 9 der elektromagnetischen Welle wird an Reflektoren 15 zu dem Empfänger 8 der Sender-Empfänger-Einheit reflektiert. Durch einen gepulsten Betrieb und eine Laufzeitmessung ist es möglich, Rückschlüsse auf die von dem aufgenommenen Signal zurückgelegte Signalstrecke zu ziehen. Gemessen wird eine Änderung einer der oben offenbarten optischen Eigenschaft der Messschicht, beispielsweise Intensität, Polarisationswinkel, Mode der TEM-Welle. Durch das vorbeschriebene Reflektionsverfahren kann auf eine exakte Ausrichtung des Senders 7 zu dem oder den Empfängern 8 entfallen, da diese mechanisch verbunden sind und die Position der Reflektoren 15 bekannt ist.

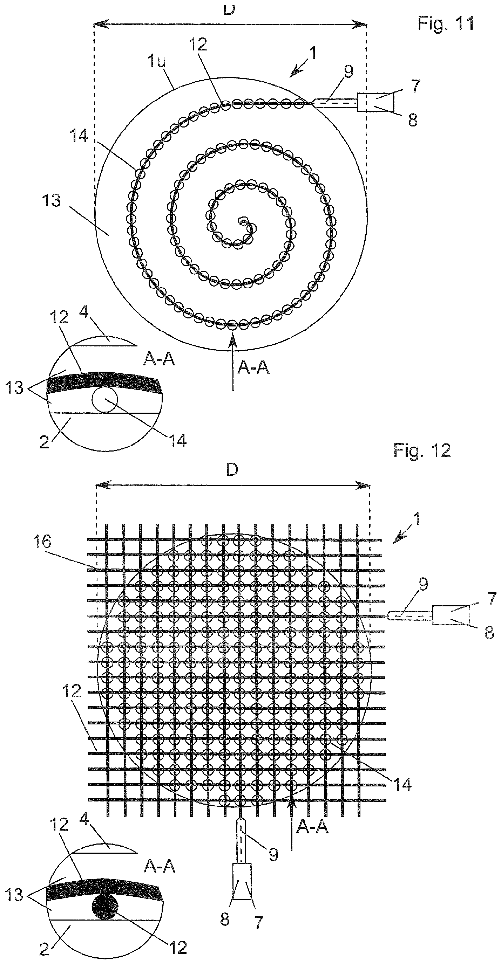

In einer weiteren Ausführungsform gemäß Figur 10 ist der Sender 7 örtlich vom Empfänger 8 getrennt, aber elektronisch mit diesem gekoppelt, so dass eine Kalibrierung des Senders 7 zum Empfänger 8 vorgenommen werden kann. Im Übrigen entspricht die Ausführungsform der Figur 10 der oben beschriebenen Ausführungsform eines Reflektionsverfahrens gemäß Figur 9. In der in Figur 11 gezeigten Ausführungsform ist das optische Material der Messschicht 3 mit einer Faseroptik 12 ausgestattet, welche in der Messschicht 3 verteilt ist. Die Fasern sind dabei vorzugsweise in ein mechanisch isotropes Material, einer Matrix, eingebettet. Die gezeigte Ausführungsform ist somit als separate Messeinrichtung in Form eines Sensors ausgeführt, wobei diese vorzugsweise aus einem ersten Substrat 2 und einem zweiten Substrat 4 sowie der dazwischen liegenden Matrix mit Faseroptik 12 und Messschicht besteht. Sender 7 und Detektoren 8 werden jeweils an Enden der Faseroptik 12 angebracht und im übrigen wie oben beschrieben verwendet, wobei der Sender 7 und der Empfänger 8 in einer Sender-Empfängereinheit untergebracht sind. Es handelt sich demnach auch ein Reflektionsverfahren. Die Sender-Empfängereinheiten werden jeweils am Ende der Faseroptik angebracht.

Erfindungsgemäß denkbar ist auch die Verwendung einer Silikonmatrix, in der die Faseroptiken 12 eingebettet werden. In diesem Fall kann auf die Substrate 2, 4 verzichtet werden und der Sensor als Matte ohne oberes und unteres Substrat ausgebildet werden.

Die Faseroptik 12 gemäß Figur 11 ist als Spirale, vorzugsweise als archimedische Spirale, aufgerollt und in eine Matrix 13 eingebettet. An vorgegebenen Positionen der Faseroptik 12 sind Referenzpunkte angeordnet, an welchen die Druckbeanspruchung ermittelbar ist. Die Referenzpunkte können durch, insbesondere kugelförmige, Druckelemente 15 gebildet werden. An diesem findet abhängig vom Druck eine Beeinflussung der optischen Eigenschaften der Faseroptik 12 statt, die mittels einer Laufzeitmessung und/oder spektralen Kodierung des Referenzpunktes zuordenbar ist. Entsprechende Sender und/oder Empfängereinheiten, welche ein Signal aussenden, und dessen Reflexion zeit- und/oder wellenlängenabhängig wieder detektieren können existieren am Markt und sind dem Fachmann als solche bekannt.

Durch die Druckbeanspruchung der Faseroptik 12 wird lokal an den Referenzpunkten die optische Eigenschaft der Faseroptik 12 geändert. Die Änderung der optischen Eigenschaft kann aufgenommen werden, insbesondere eine Doppelbrechungsänderung, eine Änderung des Brechungsindex, eine Änderung der Dichte des optischen Materials. Diese werden von der Sender-Empfängereinheit aufgenommen und ausgewertet.

Der Sender 7 ist in diesem Fall vorzugsweise eine polychromatische Quelle, mit größtem Vorzug eine polychromatische, Wellenlänge selektierende Quelle, mit der eine definierte Wellenlänge detektierbar und in die Faseroptik 12 einkoppelbar ist. Die Position eines jeden Referenzpunktes, an dem sich ein Druckelement 14 befindet, wird durch interferometrische Messung oder eine Laufzeitmessung ermittelt.

Die Druckelemente 14 weisen vorzugsweise ein hohes E-Modul auf, so dass diese Unterdruckbeanspruchung keine oder eine geringstmögliche Formänderung erfahren. Der E-Modul ist dabei insbesondere größer als 10 MPa, vorzugsweise größer 100 MPa, mit größerem Vorzug größer 1 GPa, mit größtem Vorzugzug größer 10 GPa, mit allergrößtem Vorzug größer 100 GPa, noch bevorzugter größer als 1000 GPa.

In der weiteren in Figur 12 gezeigten Ausführungsform der Erfindung sind mehrere Faseroptiken 12 in der Messschicht 3 in Form eines Gitters angeordnet. Das Gitter ist mit Vorzug rechteckig angelegt, wobei sich die jeweiligen Faseroptiken im rechten Winkel überschneiden.

Somit bilden die Faseroptiken 12 jeweils in Referenzpunkten (Kreuzungspunkte) gegenseitig Druckkörper für die jeweils kreuzende Faseroptik 12. In diesem Fall befindet sich entweder am Anfang ein Sender 7 und am Ende ein Empfänger 8 oder an einer Seite eine Sender-Empfängereinheit.

Die Messung einer Signaländerung beziehungsweise eine Änderung der optischen Eigenschaften des Signals bei Druckbeanspruchung erfolgt erfindungsgemäß an den Referenzpunkten (Kreuzungspunkte). An diesen liegen zwei Faseroptiken 12 quer zueinander und übereinander und stehen in, insbesondere direktem, Kontakt zueinander. Durch die Druckbeanspruchung in dem Kreuzungspunkt wird das optische Material der Faseroptiken 12 erfindungsgemäß komprimiert. Die Änderung der Doppelbrechung, die Änderung des Brechungsindex, Änderung der Dichte des optischen Materials oder Änderung der Mode der TEM-Welle ist entsprechend ermittelbar.

Alle Signale entlang der Breite und Länge des rechteckigen Gitters der Faseroptiken 12 werden durch die Auswerteeinheit aufgenommen und ausgewertet, wodurch die Bestimmung der Herkunft der Änderung der jeweiligen optischen Eigenschaft und somit die Umrechnung in den jeweiligen, verorteten Druckwert möglich ist.

### Bezugszeichenliste

- 1: Messeinrichtung
- 2: erstes Substrat
- 3: Messschicht
- 3u: Umfangsrand
- 4: zweites Substrat
- 5: erster Druckkörper
- 6: zweiter Druckkörper
- 7: Sender
- 8, 8': Empfänger
- 9: Signal
- 12: Faseroptik
- 13: Matrix
- 14: Druckelemente
- 15: Reflektoren
- D: Durchmesser
- L: Teilabschnitt des Messsystems
- t, t': Messschichtdicke

## Patentansprüche

1. Messeinrichtung zur Ermittlung einer Druckkarte bei einer Druckbeaufschlagung mindestens einer Messschicht (3) zwischen einem ersten Druckkörper (5) und einem zweiten Druckkörper (6) mit:
- mindestens einem an einem Umfangsrand (3u) der Messschicht (3) angeordneten Sender (7) zur Aussendung von Signalen (9) in Form elektromagnetischer Wellen entlang einer durch die Messschicht (3) verlaufenden ersten Signalstrecke und mindestens einer weiteren durch die Messschicht (3) verlaufenden Signalstrecke,
- mindestens einem am Umfangsrand (3u) angeordneten Empfänger (8, 8') zum Empfang der vom Sender (7) durch die Messschicht (3) gesendeten und bei Druckbeaufschlagung veränderbaren Signale (9) der ersten Signalstrecke und der weiteren Signalstrecke(n),
- mit einer Auswerteeinheit zur Bestimmung von verorteten Druckwerten der Druckkarte entlang der Signalstrecken der von dem mindestens einen Empfänger (8, 8') empfangenen Signale (9), wobei zur Bestimmung der Druckkarte eine Rekonstruktion der Bildsignale eines Volumens erfolgt.

2. Messeinrichtung nach Anspruch 1, die in einer Waferbearbeitungsvorrichtung, insbesondere in-situ einsetzbar ist.

3. Messeinrichtung nach wenigstens einem der vorhergehenden Ansprüche, wobei der Sender (7) und/oder der Empfänger (8, 8') entlang des Umfangsrandes (3u) bewegbar sind.

4. Messeinrichtung nach wenigstens einem der vorhergehenden Ansprüche, die mehrere am Umfangsrand (3u) verteilte Sender (7) und/oder mehrere am Umfangsrand (3u) verteilte, je einem, insbesondere gegenüberliegend angeordneten, Sender (7) zugeordnete Empfänger (8, 8') aufweist, insbesondere mindestens zwei Empfänger (8, 8') je Sender (7).

5. Messeinrichtung nach wenigstens einem der vorhergehenden Ansprüche, bei der jeder Sender (7) mehrere Signalstrecken, insbesondere gleichzeitig, aussendet und/oder jeder Empfänger (8, 8') jeweils einer einzigen Signalstrecke zugeordnet ist.

6. Messeinrichtung nach wenigstens einem der vorhergehenden Ansprüche mit der Auswerteeinheit zur Bestimmung von verorteten Druckwerten der Druckkarte entlang der Signalstrecken durch Transformation, vorzugsweise Radon-Transformation, der von dem mindestens einen Empfänger (8, 8') empfangenen Signale (9).

7. Messeinrichtung nach wenigstens einem der vorhergehenden Ansprüche, wobei der mindestens eine Empfänger (8, 8') optische Eigenschaften des Signals (9) erfassend ausgebildet ist, insbesondere eine oder mehrere der folgenden optischen Eigenschaften:
- Doppelbrechung
- Brechungsindex
- Mode von als transversal-elektromagnetischen Wellen ausgeprägten Signalen
- Laufzeit
- spektrale Kodierung.

8. Verfahren zur Ermittlung einer Druckkarte bei einer Druckbeaufschlagung einer Messschicht (3) zwischen einem ersten Druckkörper (5) und einem zweiten Druckkörper (6) mit folgenden Schritten, insbesondere folgendem Ablauf:
- Anordnung einer Messeinrichtung nach einem der vorhergehenden Ansprüche zwischen dem ersten Drückkörper (5) und dem zweiten Druckkörper (6),
- Aussendung von Signalen (9) in Form elektromagnetischer Wellen durch den oder die am Umfangsrand (3u) angeordneten Sender (7) entlang einer durch die Messschicht (3) verlaufenden ersten Signalstrecke und mindestens einer weiteren durch die Messschicht (3) verlaufenden Signalstrecke,
- Empfang der Signale (9) durch den oder die am Umfangsrand (3u) angeordneten Empfänger (8, 8') zum Empfang der von dem oder den Sender(n) (9) durch die Messschicht (3) gesendeten und bei Druckbeaufschlagung veränderbaren Signale (9) der ersten Signalstrecke und der weiteren Signalstrecke(n),
- Bestimmung von verorteten Druckwerten der Druckkarte entlang der Signalstrecken der von dem mindestens einen Empfänger (8, 8') empfangenen Signale (9), wobei zur Bestimmung der Druckkarte eine Rekonstruktion der Bildsignale eines Volumens erfolgt.

## Claims

1. A Measuring device, for determining a pressure map during application of pressure to at least one measurement layer (3) between a first pressure body (5) and a second pressure body (6), with:
- at least one transmitter (7) located on one peripheral edge (3u) of the measurement layer (3) for emission of signals (9) in the form of electromagnetic waves along a first signal route which runs through the measurement layer (3) and at least one other signal route which runs through the measurement layer (3),
- at least one receiver (8, 8') located on the peripheral edge (3u) for the reception of the signals (9) of the first signal route and other signal route(s), which signals are sent by the transmitter (7) through the measurement layer (3),
- an evaluation unit for determining localized pressure values of the pressure map along the signal routes of the signals (9) received by the receiver (8, 8'), wherein for determining the pressure map a reconstruction of the video signals of a volume is conducted.

2. The measuring device as claimed in Claim 1, which can be used in a wafer processing device, especially in-situ.

3. The measuring device as claimed in at least one of the preceding claims, wherein the transmitter (7) and/or the receiver (8, 8') can be moved along the peripheral edge (3u).

4. The measuring device as claimed in at least one of the preceding claims, which has several transmitters (7) distributed on the peripheral edge (3u) and/or several receivers (8, 8') which are distributed on the peripheral edge (3u) and which are assigned to one, especially opposite transmitter (7) at a time, especially at least two receivers (8, 8') per transmitter (7).

5. The measuring device as claimed in at least one of the preceding claims, wherein each transmitter (7) emits several signal routes, especially at the same time, and/or each receiver (8, 8') is assigned to one single signal route at a time.

6. The measuring device as claimed in at least one of the preceding claims with the evaluation unit for determining localized pressure values of the pressure map along the signal routes by a transform, preferably Radon transform, of the signals (9) received by at least one receiver (8, 8'),

7. The measuring device as claimed in at least one of the preceding claims, wherein the at least one receiver (8, 8') is made to acquire optical properties of the signal (9), especially one or more of the following optical properties:
- double refraction
- index of refraction
- mode of signals shaped as transverse electromagnetic waves
- transit time
- spectral coding.

8. A method for determining a pressure map for pressure application to a measurement layer (3) between a first pressure body (5) and a second pressure body (6), with the following steps, especially the following sequence:
- arrangement of a measuring device according to one of the preceding claims between the first pressure body (5) and the second pressure body (6),
- emission of signals (9) in the form of electromagnetic waves by the transmitter(s) (7) located on the peripheral edge (3u) along a first signal route which runs through the measurement layer (3) and at least one other signal route which runs through the measurement layer (3),
- reception of the signals (9) by the receivers) (8, 8') located on the peripheral edge (3u) for receiving the signals (9) of the first signal route and other signal route(s), which signals are sent by the transmitter(s) (9) through the measurement layer (3), determining localized pressure values of the pressure map along the signal routes of the signals (9) received by the receiver (8, 8'), wherein for determining the pressure map a reconstruction of the video signals of a volume is conducted.

## Revendications

1. Dispositif de mesure pour déterminer une carte de pression lors de la fourniture de pression à au moins d'une couche de mesure (3) entre un premier corps de pression (5) et un second corps de pression (6), comprenant :
- au moins un émetteur (7) disposé sur un bord périphérique (3u) de la couche de mesure (3) pour émettre des signaux (9) sous forme d'ondes électromagnétiques le long d'une première voie de signal passant à travers la couche de mesure (3) et au moins d'une seconde voie de signal passage à travers la couche de mesure (3),
- au moins un récepteur (8, 8') disposé sur le bord périphérique (3u) pour recevoir les signaux (9) de la première voie de signal et de l'autre/les autres voie(s) de signal envoyés par l'émetteur (7) par le biais de la couche de mesure (3) et modifiables lors de l'alimentation en pression,
- comprenant une unité d'évaluation pour définir des valeurs de pression localisées de la carte de pression le long des voies de signal des signaux (9) reçus par l'au moins un récepteur (8, 8'), dans lequel pour définir la carte de pression, une reconstruction des signaux d'image d'un volume est effectuée.

2. Dispositif de mesure selon la revendication 1, qui peut être intégré dans un dispositif de traitement de tranche, en particulier in-situ.

3. Dispositif de mesure selon au moins l'une des revendications précédentes, dans lequel l'émetteur (7) et/ou le récepteur (8, 8') sont mobiles le long du bord périphérique (3u).

4. Dispositif de mesure selon au moins l'une des revendications précédentes, qui présente plusieurs émetteurs (7) répartis sur le bord périphérique (3u) et/ou plusieurs récepteurs (8, 8') répartis sur le bord périphérique (3u) correspondant à un émetteur (7) respectif en particulier disposé opposé, en particulier au moins deux récepteurs (8, 8') par émetteur (7).

5. Dispositif de mesure selon au moins l'une des revendications précédentes, dans lequel chaque émetteur (7) émet plusieurs voies de signal, en particulier parallèlement, et/ou chaque récepteur (8, 8') est attribué respectivement à une seule voie de signal,

6. Dispositif de mesure selon au moins l'une des revendications précédentes, comprenant l'unité d'évaluation pour définir des valeurs de pression localisées de la carte de pression le long des voies de signal par transformée, de préférence par transformée de Radon des signaux (9) reçus par l'au moins un récepteur (8, 8').

7. Dispositif de mesure selon au moins l'une des revendications précédentes, dans lequel l'au moins un récepteur (8, 8') est conçu pour saisir des propriétés optiques du signal (9), en particulier une ou plusieurs des propriétés optiques suivantes :
réfraction double,
- indice de réfraction,
- mode de signaux marqués en tant qu'ondes électromagnétiques transversales,
- durée,
- codage spectral.

8. Procédé pour définir une carte de pression lors de la fourniture de pression à au moins d'une couche de mesure (3) entre un premier corps de pression (5) et un second corps de pression (6), comprenant les étapes suivantes, en particulier le déroulement suivant :
- agencement d'un dispositif de mesure selon l'une des revendications précédentes entre le premier corps de pression (5) et le second corps de pression (6),
- émission de signaux (9) sous forme d'ondes électromagnétiques par le ou les émetteur(s) (7) disposé(s) sur le bord périphérique (3u) le long d'une première voie de signal le long d'une première voie de signal passant à travers la couche de mesure (3) et au moins d'une seconde voie de signal passage à travers la couche de mesure (3),
- réception des signaux (9) par le ou les récepteur(s) (8, 8') disposé(s) sur le bord périphérique (3u) pour recevoir les signaux (9) de la première voie de signal et de l'autre/les autres voies de signal, envoyés par le ou les émetteur(s) (7) par le biais de la couche de mesure (3), et modifiables lors de l'alimentation en pression,
- détermination de valeurs de pression localisées de la carte de pression le long des voies de signal des signaux (9) reçus par au moins un récepteur (8, 8'), dans lequel pour définir la carte de pression, une reconstruction des signaux d'image d'un volume est effectuée.
